# EUROPEAN PATENT SPECIFICATION

(11) **EP 2 402 479 B1**
(45) Date of publication and mention of the grant of the patent: **21.05.2014**
(21) Application number: 11172020.7
(22) Date of filing: 29.06.2011
(51) Int. Cl.: C23C 14/08, H01L 31/0392, H01L 31/18, H01L 31/073

(54) **Method for sputtering a resistive transparent thin film for use in cadmium telluride based photovoltaic devices**
Verfahren zum Aufdampfen eines resistiven transparenten Dünnfilms zur Verwendung in Cadmiumtellurid-basierten Photovoltaikvorrichtungen
Procédé de pulvérisation de couche mince transparente resisive pour dispositifs photovoltaïques en tellurure de cadmium

(30) Priority: 02.07.2010 US 829652
(43) Date of publication of application: 04.01.2012
(73) Proprietor: First Solar Malaysia SDN.BHD, Aman (MY)
(72) Inventor: O'Keefe, Patrick Lynch, Arvada, CO Colorado 80004 (US)
(74) Representative: Thurston, Joanna

(56) References cited:
- US-A1- 2004 135 166
- GAYAM ET AL: "The structural and electrical properties of Zn-Sn-O buffer layers and their effect on CdTe solar cell performance", THIN SOLID FILMS, ELSEVIER-SEQUOIA S.A. LAUSANNE, CH, vol. 515, no. 15, 27 April 2007 (2007-04-27), pages 6060-6063, XP022212821, ISSN: 0040-6090, DOI: 10.1016/J.TSF.2006.12.165

## Description

### FIELD OF THE INVENTION

The subject matter disclosed herein relates generally to methods of deposition of a resistive transparent buffer thin film layer. More particularly, the subject matter disclosed herein relates to methods of deposition of a resistive transparent buffer thin film layer for use in cadmium telluride thin film photovoltaic devices.

### BACKGROUND OF THE INVENTION

Thin film photovoltaic (PV) modules (also referred to as "solar panels") based on cadmium telluride (CdTe) paired with cadmium sulfide (CdS) as the photo-reactive components are gaining wide acceptance and interest in the industry. CdTe is a semiconductor material having characteristics particularly suited for conversion of solar energy to electricity. For example, CdTe has an energy bandgap of about 1.45 eV, which enables it to convert more energy from the solar spectrum as compared to lower bandgap semiconductor materials historically used in solar cell applications (e.g., about 1.1 eV for silicon). Also, CdTe converts radiation energy in lower or diffuse light conditions as compared to the lower bandgap materials and, thus, has a longer effective conversion time over the course of a day or in cloudy conditions as compared to other conventional materials.

The junction of the n-type layer and the p-type layer is generally responsible for the generation of electric potential and electric current when the CdTe PV module is exposed to light energy, such as sunlight. Specifically, the cadmium telluride (CdTe) layer and the cadmium sulfide (CdS) form a p-n heterojunction, where the CdTe layer acts as a p-type layer (i.e., a positive, electron accepting layer) and the CdS layer acts as a n-type layer (i.e., a negative, electron donating layer). Free carrier pairs are created by light energy and then separated by the p-n heterojunction to produce an electrical current.

Reducing the thickness of the layers between the window glass and the cadmium telluride layer (e.g., the transparent conductive layer, the cadmium sulfide layer and any buffer layer(s) therebetween) can reduce the amount of absorption of radiation energy (e.g., solar energy) by the device prior to the energy reacting the cadmium telluride layer. Thus, the overall conversion efficiency of the device may be improved. Additionally, reducing the thickness of the cadmium sulfide layer can allow for more of the shorter wavelength radiation (e.g., blue light) to reach the cadmium telluride layer, again improving the overall conversion efficiency of the device.

However, reducing the thickness of the cadmium sulfide layers, along with any other layers between the glass and the cadmium telluride layer, can create other problems that are potentially detrimental to the performance of the device. For example, a relatively thin cadmium sulfide layer can lead to interface defects such as pinholes that create localized junctions between the transparent conductive oxide layer and the cadmium telluride layer. Such defects can lower the open circuit voltage (V_{oc}) of the device and reduce the fill factor of the device.

Thus, a need exists for cadmium telluride photovoltaic devices having improved energy conversion efficiency and/or device lifetime through reduced thicknesses of the layers between the window glass and the cadmium telluride layer, while reducing the side effects typically associated with reduced thicknesses of those layers.

GAYAM ET AL: "The structural and electrical properties of Zn-Sn-O buffer layers and their effect on CdTe solar cell performance", THIN SOLID FILMS, ELSEVIER-SEQUOIA S.A. LAUSANNE, CH, vol. 515, no. 15, 27 April 2007 (2007-04-27), pages 6060-6063, XP022212821, ISSN: 0040-6090, DOI: 10.1016/J.TSF.2006.12.165 discloses a method for the deposition of zinc tin oxide by sputtering at room temperature and subsequent recrystallization annealing at 550-625°C.

### BRIEF DESCRIPTION OF THE INVENTION

The invention relates to a method for depositing a thin film according to claim 1.

Methods are generally provided for depositing a resistive transparent buffer thin film layer on a substrate. The methods can include cold sputtering a resistive transparent buffer layer on a substrate (e.g., at a sputtering temperature of about 10° C to about 100° C) in a sputtering atmosphere comprising about 0.01% to about 5% by volume water vapor (e.g., about 0.05% to about 1% by volume water vapor). The resistive transparent buffer layer can then be annealed at an anneal temperature of about 450° C to about 700° C.

The methods of depositing a resistive transparent buffer thin film layer on a substrate can be used in a method of manufacturing a cadmium thin film photovoltaic device by forming a cadmium sulfide layer on the resistive transparent buffer layer, and forming a cadmium telluride layer on the cadmium sulfide layer.

These and other features, aspects and advantages of the present invention will become better understood with reference to the following description and appended claims. The accompanying drawings, which are incorporated in and constitute a part of this specification, illustrate embodiments of the invention and, together with the description, serve to explain the principles of the invention.

### BRIEF DESCRIPTION OF THE DRAWING

A full and enabling disclosure of the present invention, including the best mode thereof, directed to one of ordinary skill in the art, is set forth in the specification which makes reference to the appended figures, in which:
Fig. 1 shows a general schematic of a cross-sectional view of an exemplary cadmium telluride thin film photovoltaic device;
Fig. 2 shows a general schematic of a cross-sectional view of an exemplary DC sputtering chamber; and,
Fig. 3 shows a flow diagram of an exemplary method of manufacturing a photovoltaic module including a cadmium telluride thin film photovoltaic device.

Repeat use of reference characters in the present specification and drawings is intended to represent the same or analogous features or elements.

### DETAILED DESCRIPTION OF THE INVENTION

In the present disclosure, when a layer is being described as "on" or "over" another layer or substrate, it is to be understood that the layers can either be directly contacting each other or have another layer or feature between the layers. Thus, these terms are simply describing the relative position of the layers to each other and do not necessarily mean "on top of" since the relative position above or below depends upon the orientation of the device to the viewer. Additionally, although the invention is not limited to any particular film thickness, the term "thin" describing any film layers of the photovoltaic device generally refers to the film layer having a thickness less than about 10 micrometers ("microns" or "µm").

It is to be understood that the ranges and limits mentioned herein include all ranges located within the prescribed limits (i.e., subranges). For instance, a range from about 100 to about 200 also includes ranges from 110 to 150, 170 to 190, 153 to 162, and 145.3 to 149.6. Further, a limit of up to about 7 also includes a limit of up to about 5, up to 3, and up to about 4.5, as well as ranges within the limit, such as from about 1 to about 5, and from about 3.2 to about 6.5.

Generally speaking, methods are disclosed for sputtering a resistive transparent buffer layer, particularly a resistive transparent buffer (RTB) layer included in a cadmium telluride based thin film device. The resistive transparent buffer layer is generally sputtered onto the substrate in a sputtering atmosphere that includes water vapor. For example, the sputtering atmosphere can include about 0.01% to about 5% by volume water vapor, such as about 0.05% to about 1% by volume water vapor. These sputtering methods are particularly useful in "cold sputtering" followed by annealing of the as-deposited layer. For example, the RTB layer can be sputtered in a sputtering atmosphere containing water vapor at a sputtering temperature of about 10° C to about 100° C, such as about 20° C to about 50° C (e.g., about room temperature of about 20° C to about 25° C).

Adding water vapor to the sputtering chamber can reduce the voltage of the sputter cathode (i.e., the target), which can be easily monitored. Also, it has been found that a small amount of water vapor in the sputtering atmosphere (e.g., about 0.01% to about 5% by volume) can improve adhesion of the thin film layer to the substrate as it is being deposited. Finally, the as-deposited RTB layer, prior to annealing, appears to be improved due to the presence of the water vapor in the sputtering atmosphere.

Following the cold sputtering, the RTB layer can be annealed at an anneal temperature of about 450° C to about 700° C (e.g., about 500° C to about 650° C). The RTB layer can be annealed at the anneal temperature for about 5 minutes to about 5 hours, such as for about 15 minutes to about 1 hour. Without wishing to be bound by any particular theory, it is believed that annealing the RTB layer can re-crystallize the as-deposited molecules (e.g., the tin zinc oxide atoms) into a more uniform thin film layer on the substrate. Additionally, the annealing process can remove virtually all water from the as-deposited RTB layer so that the annealed RTB layer is substantially free from water molecules. As used herein, the term "substantially free" means no more than an insignificant trace amount present and encompasses completely free (e.g., 0 molar % up to 0.0001 molar %).

Sputtering deposition generally involves ejecting material from a target, which is the material source, and depositing the ejected material onto the substrate to form the film. DC sputtering generally involves applying a direct current to a metal target (i.e., the cathode) positioned near the substrate (i.e., the anode) within a sputtering chamber to form a direct-current discharge.

Besides containing water vapor, the sputtering atmosphere can also include an inert gas (e.g., argon, etc.) and/or a reactive gas (e.g., an oxygen atmosphere, nitrogen atmosphere, etc.) that forms a plasma field between the metal target and the substrate. The pressure of the sputtering atmosphere can be between about 1 mTorr and about 20 mTorr for magnetron sputtering, and can be higher for diode sputtering (e.g., from about 25 mTorr to about 100 mTorr). When metal atoms are released from the target upon application of the voltage, the metal atoms deposit onto the surface of the substrate. For example, when the atmosphere contains oxygen, the metal atoms released from the metal target can form a metallic oxide layer on the substrate.

The current applied to the source material can vary depending on the size of the source material, size of the sputtering chamber, amount of surface area of substrate, and other variables. In some embodiments, the current applied can be from about 2 amps to about 20 amps. Conversely, RF sputtering involves exciting a capacitive discharge by applying an alternating-current (AC) or radio-frequency (RF) signal between the target (e.g., a ceramic source material) and the substrate. The sputtering chamber can have an inert atmosphere (e.g., an argon atmosphere) which may or may not contain reactive species (e.g., oxygen, nitrogen, etc.) having a pressure between about 1 mTorr and about 20 mTorr for magnetron sputtering. Again, the pressure can be even higher for diode sputtering (e.g., from about 25 mTorr to about 100 mTorr).

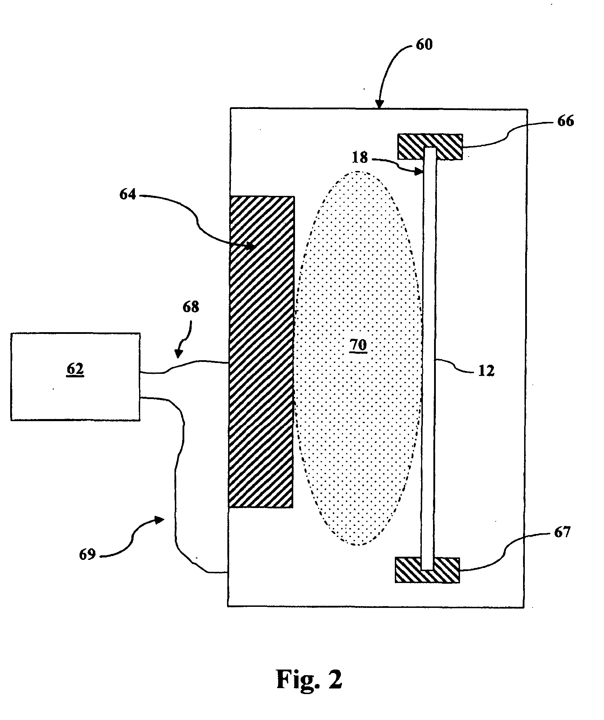

Fig. 2 shows a general schematic as a cross-sectional view of an exemplary DC sputtering chamber 60. A DC power source 62 is configured to control and supply DC power to the chamber 60. As shown, the DC power source applies a voltage to the cathode 64 to create a voltage potential between the cathode 64 and an anode formed by the chamber wall, dark shield, etc. (typically grounded), such that the substrate is in between the cathode and anode. The glass substrate 12 is held between top support 66 and bottom support 67 via wires 68 and 69, respectively. Generally, the glass substrate 12 is positioned within the sputtering chamber 60 such that the cadmium sulfide layer 18 is formed on the surface facing the cathode 64, and generally on the TCO layer 14 and RTB layer 16 (not shown) as discussed below.

A plasma field 70 is created once the sputtering atmosphere is ignited, and is sustained in response to the voltage potential between the cathode 64 and the chamber wall acting as an anode. The voltage potential causes the plasma ions within the plasma field 70 to accelerate toward the cathode 64, causing atoms from the cathode 64 to be ejected toward the surface on the glass substrate 12. As such, the cathode 64 can be referred to as a "target" and acts as the source material for the formation of the cadmium sulfide layer 18 on the surface of the glass substrate 12 facing the cathode 64. To form the cadmium sulfide layer, the cathode 64 can be a metal alloy target, such as of cadmium sulfide. Additionally, in some embodiments, a plurality of cathodes 64 can be utilized. A plurality of cathodes 64 can be particularly useful to form a layer including several types of materials (e.g., co-sputtering). Since the sputtering atmosphere contains oxygen gas, oxygen particles of the plasma field 70 can react with the ejected target atoms to form a cadmium sulfide layer 18 that includes oxygen.

Although only a single DC power source 62 is shown, the voltage potential can be realized through the use of multiple power sources coupled together. Additionally, the exemplary sputtering chamber 60 is shown having a vertical orientation, although any other configuration can be utilized. After exiting the sputtering chamber 60, the substrate 12 can enter an adjacent annealing oven (not shown) to begin the annealing process.

The RTB layer can include, for instance, a combination of zinc oxide (ZnO) and tin oxide (SnO₂), which can be referred to as a zinc tin oxide layer ("ZTO"). In one particular embodiment, the RTB layer can include more tin oxide than zinc oxide. For example, the RTB layer can have a composition with a stoichiometric ratio of ZnO/SnO₂ between about 0.25 and about 3, such as in about an one to two (1:2) stoichiometric ratio of tin oxide to zinc oxide. The RTB layer 16 can be formed using a DC sputtering method by applying a DC current to a metallic source material (e.g., elemental zinc, elemental tin, or a mixture thereof) and sputtering the metallic source material onto the TCO layer 14 in the presence of an oxidizing atmosphere (e.g., O₂ gas). When the oxidizing atmosphere includes oxygen gas (i.e., O₂), the atmosphere can be greater than about 95% oxygen by volume, such about 95% to about 99% by volume, with the balance of the sputtering atmosphere water vapor.

In one embodiment, the sputtering atmosphere can include about 1% to about 25% oxygen, in addition to the water vapor, and an inert gas (e.g., argon). In another embodiment, the sputtering atmosphere can include only water vapor and an inert gas (e.g., argon).

In one particular embodiment, the RTB layer can be formed for use in a cadmium telluride based thin film photovoltaic device. The RTB layer can generally be positioned between a transparent conductive oxide (TCO) layer and a cadmium sulfide layer in the cadmium telluride thin film photovoltaic device, and allows for a relatively thin cadmium sulfide layer to be included in the device by reducing the possibility of interface defects (i.e., "pinholes" in the cadmium sulfide layer) creating shunts between the TCO layer and the cadmium telluride layer. Thus, without wishing to be bound by any particular theory, it is believed that the RTB layer allows for improved adhesion and/or interaction between the TCO layer and the cadmium telluride layer, thereby allowing a relatively thin cadmium sulfide layer to be formed thereon without significant adverse effects that would otherwise result from such a relatively thin cadmium sulfide layer formed directly on the TCO layer. Additionally, the RTB layer is generally more resistive than the TCO layer and can help protect the device from chemical interactions between the TCO layer and the subsequent layers during processing of the device. For example, in certain embodiments, the RTB layer can have a sheet resistance that is greater than about 1000 ohms per square, such as from about 10 kOhms per square to about 1000 MOhms per square. The RTB layer 16 can also have a wide optical bandgap (e.g., greater than about 2.5 eV, such as from about 2.7 eV to about 3.0 eV).

In certain embodiments, the RTB layer 16 can have a thickness of about 0.075 µm and about 1 µm, for example about 0.1 µm to about 0.5 µm. In particular embodiments, the RTB layer 16 can have a thickness of about 0.08 µm and about 0.2 µm, for example of about 0.1 µm to about 0.15 µm.

The presently provided methods of sputtering a RTB layer in a sputtering atmosphere including water vapor can be utilized in the formation of any film stack that utilizes a RTB layer. For example, the RTB layer can be used during the formation of any cadmium telluride device that utilizes a cadmium telluride layer, such as in the cadmium telluride thin film photovoltaic device disclosed in U.S. Publication No. 2009/0194165 of Murphy, et al. titled "Ultra-high Current Density Cadmium Telluride Photovoltaic Modules."

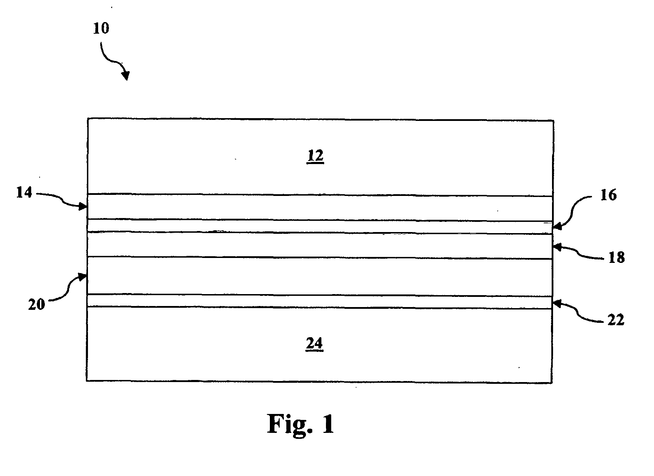

Fig. 1 represents an exemplary cadmium telluride thin film photovoltaic device 10 that can be formed according to methods described herein. The exemplary device 10 of Fig. 1 includes a top sheet of glass 12 employed as the substrate. In this embodiment, the glass 12 can be referred to as a "superstrate," as it is the substrate on which the subsequent layers are formed even though it faces upward to the radiation source (e.g., the sun) when the cadmium telluride thin film photovoltaic device 10 is in used. The top sheet of glass 12 can be a high-transmission glass (e.g., high transmission borosilicate glass), low-iron float glass, or other highly transparent material. The glass is generally thick enough to provide support for the subsequent film layers (e.g., from about 0.5 mm to about 10 mm thick), and is substantially flat to provide a good surface for forming the subsequent film layers. In one embodiment, the glass 12 can be a low iron float glass containing less than about 0.015% by weight iron (Fe), and may have a transmissiveness of about 0.9 or greater in the spectrum of interest (e.g., wavelengths from about 300 nm to about 900 nm). In another embodiment, borosilicate glass may be utilized so as to better withstand high temperature processing.

The transparent conductive oxide (TCO) layer 14 is shown on the glass 12 of the exemplary device 10 of Fig. 1. The TCO layer 14 allows light to pass through with minimal absorption while also allowing electric current produced by the device 10 to travel sideways to opaque metal conductors (not shown). For instance, the TCO layer 14 can have a sheet resistance less than about 30 ohm per square, such as from about 4 ohm per square to about 20 ohm per square (e.g., from about 8 ohm per square to about 15 ohm per square). In certain embodiments, the TCO layer 14 can have a thickness between about 0.1 µm and about 1 µm, for example from about 0.1 µm to about 0.5 µm, such as from about 0.25 µm to about 0.35 µm.

A resistive transparent buffer layer 16 (RTB layer) is shown on the TCO layer 14 on the exemplary cadmium telluride thin film photovoltaic device 10, and is described in greater detail above.

A cadmium sulfide layer 18 is shown on RTB layer 16 of the exemplary device 10 of Fig. 1. The cadmium sulfide layer 18 is a n-type layer that generally includes cadmium sulfide (CdS), but may also include other materials, such as zinc sulfide, cadmium zinc sulfide, etc., and mixtures thereof as well as dopants and other impurities. The cadmium sulfide layer 18 can have a wide band gap (e.g., from about 2.25 eV to about 2.5 eV, such as about 2.4 eV) in order to allow most radiation energy (e.g., solar radiation) to pass. As such, the cadmium sulfide layer 18 is considered a transparent layer on the device 10.

The cadmium sulfide layer 18 can be formed by sputtering, chemical vapor deposition, chemical bath deposition, and other suitable deposition methods. In one particular embodiment, the cadmium sulfide layer 18 can be formed by sputtering (e.g., direct current (DC) sputtering or radio frequency (RF) sputtering) on the resistive transparent layer 16.

Due to the presence of the resistive transparent layer 16, the cadmium sulfide layer 18 can have a thickness that is less than about 0.1 µm, such as between about 10 nm and about 100 nm, such as from about 50 nm to about 80 nm, with a minimal presence of pinholes between the resistive transparent layer 16 and the cadmium sulfide layer 18. Additionally, a cadmium sulfide layer 18 having a thickness less than about 0.1 µm reduces any absorption of radiation energy by the cadmium sulfide layer 18, effectively increasing the amount of radiation energy reaching the underlying cadmium telluride layer 22.

A cadmium telluride layer 20 is shown on the cadmium sulfide layer 18 in the exemplary cadmium telluride thin film photovoltaic device 10 of Fig. 1. The cadmium telluride layer 20 is a p-type layer that generally includes cadmium telluride (CdTe) but may also include other materials. As the p-type layer of device 10, the cadmium telluride layer 20 is the photovoltaic layer that interacts with the cadmium sulfide layer 18 (i.e., the n-type layer) to produce current from the absorption of radiation energy by absorbing the majority of the radiation energy passing into the device 10 due to its high absorption coefficient and creating electron-hole pairs. For example, the cadmium telluride layer 20 can generally be formed from cadmium telluride and can have a bandgap tailored to absorb radiation energy (e.g., from about 1.4 eV to about 1.5 eV, such as about 1.45 eV) to create the maximum number of electron-hole pairs with the highest electrical potential (voltage) upon absorption of the radiation energy. Electrons may travel from the p-type side (i.e., the cadmium telluride layer 20) across the junction to the n-type side (i.e., the cadmium sulfide layer 18) and, conversely, holes may pass from the n-type side to the p-type side. Thus, the p-n junction formed between the cadmium sulfide layer 18 and the cadmium telluride layer 20 forms a diode in which the charge imbalance leads to the creation of an electric field spanning the p-n junction. Conventional current is allowed to flow in only one direction and separates the light induced electron-hole pairs.

The cadmium telluride layer 20 can be formed by any known process, such as vapor transport deposition, chemical vapor deposition (CVD), spray pyrolysis, electrodeposition, sputtering, close-space sublimation (CSS), etc. In one particular embodiment, the cadmium sulfide layer 18 is deposited by a sputtering and the cadmium telluride layer 20 is deposited by close-space sublimation. In particular embodiments, the cadmium telluride layer 20 can have a thickness between about 0.1 µm and about 10 µm, such as from about 1 µm and about 5 µm. In one particular embodiment, the cadmium telluride layer 20 can have a thickness between about 2 µm and about 4 µm, such as about 3 µm.

A series of post-forming treatments can be applied to the exposed surface of the cadmium telluride layer 20. These treatments can tailor the functionality of the cadmium telluride layer 20 and prepare its surface for subsequent adhesion to the back contact layer(s) 22. For example, the cadmium telluride layer 20 can be annealed at elevated temperatures (e.g., from about 350° C to about 500° C, such as from about 375° C to about 424° C) for a sufficient time (e.g., from about 1 to about 10 minutes) to create a quality p-type layer of cadmium telluride. Without wishing to be bound by theory, it is believed that annealing the cadmium telluride layer 20 (and the device 10) converts the normally lightly p-type doped, or even n-type doped cadmium telluride layer 20 to a more strongly p-type cadmium telluride layer 20 having a relatively low resistivity. Additionally, the cadmium telluride layer 20 can recrystallize and undergo grain growth during annealing.

Annealing the cadmium telluride layer 20 can be carried out in the presence of cadmium chloride in order to dope the cadmium telluride layer 20 with chloride ions. For example, the cadmium telluride layer 20 can be washed with an aqueous solution containing cadmium chloride and then annealed at the elevated temperature.

In one particular embodiment, after annealing the cadmium telluride layer 20 in the presence of cadmium chloride, the surface can be washed to remove any cadmium oxide formed on the surface. This surface preparation can leave a Te-rich surface on the cadmium telluride layer 20 by removing oxides from the surface, such as CdO, CdTeO₃, CdTe₂O₅, etc. For instance, the surface can be washed with a suitable solvent (e.g., ethylenediamine also known as 1,2 diaminoethane or "DAE") to remove any cadmium oxide from the surface.

Additionally, copper can be added to the cadmium telluride layer 20. Along with a suitable etch, the addition of copper to the cadmium telluride layer 20 can form a surface of copper-telluride on the cadmium telluride layer 20 in order to obtain a low-resistance electrical contact between the cadmium telluride layer 20 (i.e., the p-type layer) and the back contact layer(s). Specifically, the addition of copper can create a surface layer of cuprous telluride (Cu₂Te) between the cadmium telluride layer 20 and the back contact layer 22. Thus, the Te-rich surface of the cadmium telluride layer 20 can enhance the collection of current created by the device through lower resistivity between the cadmium telluride layer 20 and the back contact layer 22.

Copper can be applied to the exposed surface of the cadmium telluride layer 20 by any process. For example, copper can be sprayed or washed on the surface of the cadmium telluride layer 20 in a solution with a suitable solvent (e.g., methanol, water, or the like, or combinations thereof) followed by annealing. In particular embodiments, the copper may be supplied in the solution in the form of copper chloride, copper iodide, or copper acetate. The annealing temperature is sufficient to allow diffusion of the copper ions into the cadmium telluride layer 20, such as from about 125° C to about 300° C (e.g. from about 150° C to about 200° C) for about 5 minutes to about 30 minutes, such as from about 10 to about 25 minutes.

A back contact layer 22 is shown on the cadmium telluride layer 20. The back contact layer 22 generally serves as the back electrical contact, in relation to the opposite, TCO layer 14 serving as the front electrical contact. The back contact layer 22 can be formed on, and in one embodiment is in direct contact with, the cadmium telluride layer 20. The back contact layer 22 is suitably made from one or more highly conductive materials, such as elemental nickel, chromium, copper, tin, aluminum, gold, silver, technetium or alloys or mixtures thereof. Additionally, the back contact layer 22 can be a single layer or can be a plurality of layers. In one particular embodiment, the back contact layer 22 can include graphite, such as a layer of carbon deposited on the p-layer followed by one or more layers of metal, such as the metals described above. The back contact layer 22, if made of or comprising one or more metals, is suitably applied by a technique such as sputtering or metal evaporation. If it is made from a graphite and polymer blend, or from a carbon paste, the blend or paste is applied to the semiconductor device by any suitable method for spreading the blend or paste, such as screen printing, spraying or by a "doctor" blade. After the application of the graphite blend or carbon paste, the device can be heated to convert the blend or paste into the conductive back contact layer. A carbon layer, if used, can be from about 0.1 µm to about 10 µm in thickness, for example from about 1 µm to about 5 µm. A metal layer of the back contact, if used for or as part of the back contact layer 22, can be from about 0.1 µm to about 1.5 µm in thickness.

The encapsulating glass 24 is also shown in the exemplary cadmium telluride thin film photovoltaic device 10 of Fig. 1.

Other components (not shown) can be included in the exemplary device 10, such as bus bars, external wiring, laser etches, etc. For example, when the device 10 forms a photovoltaic cell of a photovoltaic module, a plurality of photovoltaic cells can be connected in series in order to achieve a desired voltage, such as through an electrical wiring connection. Each end of the series connected cells can be attached to a suitable conductor such as a wire or bus bar, to direct the photovoltaically generated current to convenient locations for connection to a device or other system using the generated electric. A convenient means for achieving such series connections is to laser scribe the device to divide the device into a series of cells connected by interconnects. In one particular embodiment, for instance, a laser can be used to scribe the deposited layers of the semiconductor device to divide the device into a plurality of series connected cells.

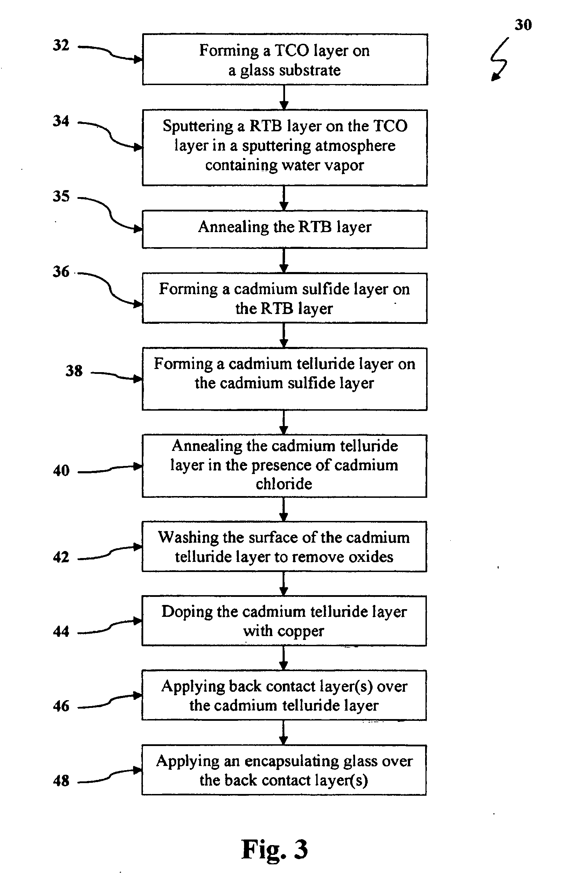

Fig. 3 shows a flow diagram of an exemplary method 30 of manufacturing a photovoltaic device. According to the exemplary method 30, a TCO layer is formed on a glass substrate at 32. At 34, a resistive transparent buffer layer is sputtered on the TCO layer in a sputtering atmosphere containing water vapor, and annealed at 35. A cadmium sulfide layer is formed on the resistive transparent buffer layer at 36. A cadmium telluride layer is formed on the cadmium sulfide layer at 38. The cadmium telluride layer can be annealed in the presence of cadmium chloride at 40, and washed to remove oxides formed on the surface at 42. The cadmium telluride layer can be doped with copper at 44. At 46, back contact layer(s) can be applied over the cadmium telluride layer, and an encapsulating glass can be applied over the back contact layer at 48.

One of ordinary skill in the art should recognize that other processing and/or treatments can be included in the method 30. For instance, the method may also include laser scribing to form electrically isolated photovoltaic cells in the device. These electrically isolated photovoltaic cells can then be connected in series to form a photovoltaic module. Also, electrical wires can be connected to positive and negative terminals of the photovoltaic module to provide lead wires to harness electrical current produced by the photovoltaic module.

This written description uses examples to disclose the invention, including the best mode, and also to enable any person skilled in the art to practice the invention, including making and using any devices or systems and performing any incorporated methods. The patentable scope of the invention is defined by the claims, and may include other examples that occur to those skilled in the art.

## Claims

1. A method for depositing a resistive transparent buffer thin film layer (16) on a substrate (12), the method comprising:
sputtering a resistive transparent buffer layer (16) comprising a zinc tin oxide onto a substrate (12) at a sputtering temperature of 10°C to 100°C in a sputtering atmosphere comprising 0.01% to 5% by volume water vapor; and,
annealing the resistive transparent buffer layer (16) at an anneal temperature of 450°C to 700°C to re-crystallize the molecules of the resistive transparent buffer layer deposited during the sputtering step.

2. The method of claim 1, wherein the sputtering atmosphere comprises 0.05% to 1% by volume water vapor.

3. The method of any preceding claim, wherein the sputtering atmosphere further comprises oxygen.

4. The method of any preceding claim, wherein the sputtering atmosphere comprises 1% to 25% oxygen.

5. The method of any preceding claim, wherein any water molecules deposited on or in the resistive transparent buffer layer (16) are vaporized out of the resistive transparent buffer layer (16) during annealing.

6. The method of any preceding claim, wherein the resistive transparent buffer layer is annealed for 5 minutes to 5 hours.

7. The method of any preceding claim, wherein the resistive transparent buffer layer is annealed for 15 minutes to 1 hour.

8. The method of any preceding claim, wherein the resistive transparent buffer layer (16) is sputtered onto a conductive transparent oxide layer (14) on the substrate (12).

9. A method of manufacturing a cadmium thin film photovoltaic device, the method comprising:
depositing a resistive transparent buffer thin film layer (16) on a substrate (12) according to any preceding claim;
forming a cadmium sulfide layer on the resistive transparent buffer layer; and,
forming a cadmium telluride layer on the cadmium sulfide layer.

10. The method of claim 9, further comprising:
forming a conductive transparent oxide layer (14) on the substrate (12) prior to sputtering the resistive transparent buffer layer (16).

11. The method of claim 9 or claim 10, wherein the resistive transparent buffer layer (16) has a thickness of 0.075 µm to 1 µm.

## Patentansprüche

1. Verfahren zum Abscheiden einer resistiven durchlässigen Dünnfilmpufferschicht (16) auf einem Substrat (12), wobei das Verfahren umfasst:
Aufdampfen einer resistiven durchlässigen Pufferschicht (16), die ein Zinkzinnoxid auf einem Substrat (12) bei einer Aufdampftemperatur von 10 °C bis 100 °C in einer Aufdampfatmosphäre umfasst, die 0,01 % bis 5 % Wasserdampf bezogen auf das Volumen umfasst; und
Tempern der resistiven durchlässigen Pufferschicht (16) bei einer Tempertemperatur von 450 °C bis 700 °C, um die Moleküle der resistiven durchlässigen Pufferschicht, die während des Schritts des Aufdampfens abgeschieden worden sind, zu rekristallisieren.

2. Verfahren nach Anspruch 1, wobei die Aufdampfatmosphäre 0,05 bis 1 Vol.%. Wasserdampf umfasst.

3. Verfahren nach einem vorhergehenden Anspruch, wobei die Aufdampfatmosphäre ferner Sauerstoff umfasst.

4. Verfahren nach einem vorhergehenden Anspruch, wobei die Aufdampfatmosphäre 1 % bis 25 % Sauerstoff umfasst.

5. Verfahren nach einem vorhergehenden Anspruch, wobei jedes Wassermolekül, das auf oder in der resistiven durchlässigen Pufferschicht (16) abgeschieden worden ist, während des Temperns aus der resistiven durchlässigen Pufferschicht (16) verdampft.

6. Verfahren nach einem vorhergehenden Anspruch, wobei die resistive durchlässige Pufferschicht während einer Zeitdauer von 5 Minuten bis 5 Stunden getempert wird.

7. Verfahren nach einem vorhergehenden Anspruch, wobei die resistive durchlässige Pufferschicht während einer Zeitdauer von 15 Minuten bis 1 Stunde getempert wird.

8. Verfahren nach einem vorhergehenden Anspruch, wobei die resistive durchlässige Pufferschicht (16) auf einer leitfähigen durchlässigen Oxidschicht (14) auf dem Substrat (12) aufgedampft wird.

9. Verfahren zum Herstellen einer Photovoltaikvorrichtung aus einem Cadmiumdünnfilm, wobei das Verfahren umfasst:
Abscheiden einer resistiven durchlässigen Pufferschicht (16) auf einem Substrat (12) nach einem vorhergehenden Anspruch;
Bilden einer Cadmiumsulfidschicht auf der resistiven durchlässigen Pufferschicht; und
Bilden einer Cadmiumtelluridschicht auf der Cadmiumsulfidschicht.

10. Verfahren nach Anspruch 9, das ferner umfasst:
Bilden einer leitfähigen durchlässigen Oxidschicht (14) auf dem Substrat (12), bevor die resistive durchlässige Pufferschicht (16) aufgedampft wird.

11. Verfahren nach Anspruch 9 oder 10, wobei die resistive durchlässige Pufferschicht (16) eine Dicke von 0,075 µm bis 1 µm aufweist.

## Revendications

1. Procédé de dépôt d'une couche de film mince tampon transparente résistive (16) sur un substrat (12), le procédé comprenant :
la pulvérisation d'une couche tampon transparente résistive (16) comprenant un oxyde de zinc-étain sur un substrat (12) à une température de pulvérisation de 10 °C à 100 °C dans une atmosphère de pulvérisation comprenant 0,01 % à 5 % en volume de vapeur d'eau ; et,
le recuit de la couche tampon transparente résistive (16) à une température de recuit de 450 °C à 700 °C afin de recristalliser les molécules de la couche tampon transparente résistive déposée pendant l'étape de pulvérisation.

2. Procédé selon la revendication 1, dans lequel l'atmosphère de pulvérisation comprend 0,05 % à 1 % en volume de vapeur d'eau.

3. Procédé selon l'une quelconque des revendications précédentes, dans lequel l'atmosphère de pulvérisation comprend en outre de l'oxygène.

4. Procédé selon l'une quelconque des revendications précédentes, dans lequel l'atmosphère de pulvérisation comprend 1 % à 25 % d'oxygène.

5. Procédé selon l'une quelconque des revendications précédentes, dans lequel toute molécule d'eau déposée sur ou dans la couche tampon transparente résistive (16) est vaporisée hors de la couche tampon transparente résistive (16) pendant le recuit.

6. Procédé selon l'une quelconque des revendications précédentes, dans lequel la couche tampon transparente résistive est recuite pendant 5 minutes à 5 heures.

7. Procédé selon l'une quelconque des revendications précédentes, dans lequel la couche tampon transparente résistive est recuite pendant 15 minutes à 1 heure.

8. Procédé selon l'une quelconque des revendications précédentes, dans lequel la couche tampon transparente résistive (16) est pulvérisée sur une couche d'oxyde transparente conductrice (14) sur le substrat (12).

9. Procédé de fabrication d'un dispositif photovoltaïque à film mince de cadmium, le procédé comprenant :
le dépôt d'une couche de film mince tampon transparente résistive (16) sur un substrat (12) selon l'une quelconque des revendications précédentes ;
la formation d'une couche de sulfure de cadmium sur la couche tampon transparente résistive ; et,
la formation d'une couche de tellurure de cadmium sur la couche de sulfure de cadmium.

10. Procédé selon la revendication 9, comprenant en outre :
la formation d'une couche d'oxyde transparente conductrice (14) sur le substrat (12) avant la pulvérisation de la couche tampon transparente résistive (16).

11. Procédé selon la revendication 9 ou la revendication 10, dans lequel la couche tampon transparente résistive (16) a une épaisseur de 0,075 µm à 1 µm.
